# EUROPÄISCHE PATENTSCHRIFT

(11) **EP 1 581 666 B1**
(45) Veröffentlichungstag und Bekanntmachung des Hinweises auf die Patenterteilung: **20.08.2008**
(21) Anmeldenummer: 03779668.7
(22) Anmeldetag: 25.10.2003
(51) Int. Cl.: C23C 14/06

(54) **BESCHICHTUNG FÜR EIN kUNSTSTOFFSUSBSTRAT**
COATING FOR A PLASTIC SUBSTRATE
REVETEMENT DESTINE A UN SUBSTRAT PLASTIQUE

(30) Priorität: 08.11.2002 DE 10252543
(43) Veröffentlichungstag der Anmeldung: 05.10.2005
(73) Patentinhaber: Applied Materials GmbH & Co. KG, 63755 Alzenau (DE)
(72) Erfinder: KREMPEL-HESSE, Jörg, 63683 Eckartsborn (DE); HACKER, Volker, 63674 Altenstadt-Oberau (DE); ZMELTY, Anton, 63768 Hösbach (DE); GRIMM, Helmut, 64291 Darmstadt (DE)
(74) Vertreter: Schickedanz, Willi
(86) Internationale Anmeldenummer: PCT/DE2003/003549
(87) Internationale Veröffentlichungsnummer: WO 2004/042107

(56) Entgegenhaltungen:
- EP-A- 0 753 601
- EP-A- 0 950 725
- EP-A- 1 130 420
- WO-A-00/55392
- WO-A-80/00713
- WO-A-91/16197
- WO-A1-96/28587
- DE-A- 19 859 695
- DE-C1- 10 143 145
- FR-A- 1 496 205
- GB-A- 2 143 910
- US-A- 5 660 892
- US-B1- 6 196 154
- UTZ H.: 'Barriereeigenschaften von aluminiumbedampften Kunststofffolien' VERPACKUNGSRUNDSCHAU vol. 43, no. 3, 1992, pages 17 - 24
- HANIKA MARKUS: 'Zur Permeation durch aluminiumbedampfte Polypropylen- und Polyethylenterephtalatfolien', July 2004, SHAKER
- UTZ H.: 'Barriereeigenschaften aluminiumbedampfter Kunststoffolien' DISSERTATION, TU MÜNCHEN 24 May 1995, MONCHEN, page 60-63, 166,167

## Beschreibung

Die Erfindung betrifft eine Beschichtung für ein Kunststoffsubstrat nach dem Oberbegriff des Patentanspruchs 1.

Dreidimensionale Hohlkörper, beispielsweise Flaschen für Wein, Bier, Limonade oder Wasser, sind entweder klarsichtig oder eingefärbt. So sind Bierflaschen in der Regel braun, um eine Beschädigung des Biers durch Lichteinwirkung zu verhindern. Weinflaschen sind dagegen weiß, grün oder braun. Die Farben dieser Flaschen werden durch eine entsprechende Einfärbung des Glases erreicht. Auch bei Flaschen aus Kunststoff, die farbig sind, wird die Farbe durch Einfärbung des Kunststoffs erzielt. Weiße und durchsichtige Kunststoffflaschen können nachträglich dadurch mit einer Farbe versehen werden, dass man einen entsprechenden Lack aufbringt.

Bei Gegenständen, die keine dreidimensionalen Hohlkörper sind, werden Farbeffekte auch noch nachträglich durch Aufbringen dünner Schichten erzeugt.

So ist ein Verfahren zum Herstellen von Sonnenschutzscheiben mit neutralen Transmissionsfarben, vorgegebenen Reflexionsfarben sowie vorgegebenen Wärmereflexionseigenschaften bekannt, bei dem auf einer Glasscheibe zunächst eine Metalloxidschicht, z. B. aus Sn-Oxid, Ti-Oxid oder Al-Oxid aufgebracht wird, dann eine Schicht Chromnitrid und anschließend gegebenenfalls noch einmal eine Metalloxidschicht (DE 33 11 815 A1). Diese Schichten müssen nicht gasdicht sein, weil das Substrat, auf dem sie aufgebracht sind - das Glas -, ohnehin gasdicht ist.

Weiterhin ist eine Antiwärmeverglasung mit modifizierten optischen Eigenschaften bekannt, bei welcher auf dem Glassubstrat eine erste Metalloxid-Schicht aufgebracht ist (DE 15 96 825 A1). Als Metalloxid wird beispielsweise Zinnoxid verwendet, auf dem noch eine Schicht Chromnitrid angebracht werden kann, auf der sich eine weitere Schicht Zinnoxid befindet.

Bei einem anderen Schichtsystem für die Steuerung der Ein- und/oder Ausstrahlung von Licht durch Fensterscheiben ist auf dem Glassubstrat ein Metalloxid, auf dem Metalloxid ein Metall und auf dem Metall wieder ein Metalloxid aufgebracht, wobei das Metalloxid einen Brechungsindex zwischen 2,2 und 2,7 hat (DE 197 45 881 A1). Bei dem Substrat handelt es sich indessen um flächiges Glas und nicht um einen räumlichen Hohlkörper aus Kunststoff.

Es ist ferner ein Verfahren für das Erzeugen eines halbtransparenten metallischen Aussehens eines Kosmetikkoffers bekannt, der aus durchsichtigem Kunststoff besteht (WO 02/20282). Dieses Verfahren besteht darin, dass in einer physikalischen Vakuumdampfphase ein Metallfilm aufgebracht wird, der ausreichend dünn ist, um nicht undurchsichtig zu sein. Dieser dünne Film wird dann mit Lack überzogen.

Außerdem ist es bekannt, ein Kunststoffsubstrat mit einer Aluminiumschicht zu versehen, wobei die Aluminiumschicht eine Dicke von 300 bis 3000 Angström (30 bis 300 nm) hat. Auf die Aluminiumschicht wird dann noch eine Kunststoffschicht aufgebracht. Behälter und Flaschen sollen hierdurch ihren metallischen Glanz wieder erhalten, nachdem sie zum Zwecke der Sterilisierung mit Dampf behandelt wurden (JP-Patent 59 106958 A).

Räumliche Hohlkörper aus Kunststoff, beispielsweise die bereits erwähnten Getränkeflaschen, sind nicht hinreichend diffusionsdicht gegen Gase und Dämpfe. Ein kohlendioxidhaltiges Getränk schmeckt schal, wenn dieses Gas in zu hohem Maß durch die Behälterwand nach außen diffundiert. Andererseits leiden Aromen oder Duftstoffe, wenn Sauerstoff von außen in den Behälter gelangt und diese durch Oxidation zerstört oder verändert werden.

Um räumliche Hohlkörper aus Kunststoff gegen flüchtige Substanzen und Gase dicht zu machen, ist es bekannt, eine Schicht aus SiO₂ bzw. SiOₓ auf der Außen- oder Innenseite des Hohlkörpers anzubringen (DE 198 07 032 A1; John T. Felts: Transparent Gas Barrier Technologies, Society of Vacuum Coaters, 1990, S. 184 - 193; DE 44 38 359 A1; DE 198 49 205 A1).

Weiterhin ist ein Verfahren zum Beschichten von Substraten aus Kunststoff mit einer das Licht reflektierenden Schicht, vorzugsweise einer Aluminiumschicht, bekannt, wobei zwischen einem Substrat und der lichtreflektierenden Schicht eine weitere Schicht angeordnet ist (DE 198 59 695 A1). Die weitere Schicht ist dabei z. B. eine Oxidschicht.

Ferner ist ein Beschichtungsverfahren bekannt, nach dem Spiegel in einer umweltverträglichen und im Wesentlichen verschmutzungsfreien Weise hergestellt werden können (WO 91/16197 A).

Des Weiteren sind ein Verfahren und eine Einrichtung zur Herstellung von Schichtsystemen für optische Präzisionsbauelemente bekannt, die auf einem Substrat einen Stapel von abwechselnd hoch- und niedrigbrechenden optisch wirksamen Schichten enthalten, wobei die Abscheidung einzelner Schichten durch Pulsmagnetron-Sputterstationen erfolgt, die an einem konstant gehaltenen Arbeitspunkt im "Transientmode" reaktiv betrieben werden. Das Substrat wird dabei durch gleichförmige Linearbewegung an der jeweiligen Pulsmagnetron-Sputterstation mit dem zugehörigen Targetmaterial, aus dem die Schicht reaktiv gebildet wird, mit einer vorgegebenen Geschwindigkeit V₁ vorbeigeführt. Dabei wird V₁ bei der Abscheidung einzelner Schichten so eingestellt, dass nach einer vorgegebenen Anzahl von Passagen die jeweilige Schicht bis zu einer Dicke von mindestens 50 % der Sollschichtdicke aufgebracht wird. Anschließend wird auf dem Substrat eine optische Präzisionsmessung der Transmission und/oder der Reflexion und/oder der Polarisation des Teilschichtsystems durchgeführt. Deren Ergebnis wird mit dem Sollwert verglichen, der nach vollständiger Abscheidung der jeweiligen Schicht erreicht werden muss (DE 101 43 145 C1).

Bekannt ist auch eine Luftschleuse für das kontinuierliche Ein- bzw. Ausbringen eines Werkstückes von einem äußeren Raum und einem Behandlungsraum, wobei diese atmosphärisch durch zumindest einen Transferkanal miteinander verbunden sind (US 6 196 154 B1).

Ein Verfahren zur Herstellung von Barriereschichten für gasförmige und/oder flüssige Substanzen auf Substraten, insbesondere Kunststoffsubstraten, mittels eines durch Plasma geschützten Gasphasenabscheideverfahrens ist ebenfalls bekannt (EP 0 950 725 A2). Dabei wird auf dem Substrat mindestens eine Schichtlage einer anorganischen Schichtsubstanz mit einer Matrix, bestehend aus einer Oxid-Verbindung oder aus einer Nitrid-Verbindung sowie Kohlenstoffanteilen, abgeschieden.

Des Weiteren ist ein Verfahren zur Herstellung eines Metallfilms bekannt (US 5 660 892). Es wird dabei auf einem organischen Polymersubstrat eine reaktive Schwefeloberfläche bereitgestellt. Auf diese Oberfläche wird ein Metall aufgebracht, wobei über die Schwefel-Metallwechselwirkungen eine Metallschicht, gebildet wird.

Zur Verbesserung der Barrierewirkung ist es auch bekannt, in eine SiO₂-Schicht mindestens ein Metall aus der Gruppe Antimon, Aluminium, Chrom, Kobalt, Kupfer, Indium, Eisen, Blei, Mangan, Zinn, Titan, Wolfram, Zink und Zirkonium einzulagern (EP 0 460 796 A2).

Hierdurch wird jedoch noch kein dekorativer Effekt erzielt.

Der Erfindung liegt deshalb die Aufgabe zugrunde, eine Sperrschicht für dreidimensionale Hohlkörper zu schaffen, die gleichzeitig einen dekorativen Effekt bewirkt, wobei die Herstellung der Sperrschicht kostengünstig erfolgen kann.

Diese Aufgabe wird gemäß den Merkmalen des Patentanspruchs 1 gelöst.

Die Erfindung betrifft somit einen räumlichen Hohlkörper aus Kunststoff mit einer Beschichtung die wenigstens eine Schicht eines Materials enthält, bei dem die Absorption von sichtbarem Licht im sichtbaren Bereich vernachlässigbar ist. Die Dicke der Schicht aus diesem Material ist dabei a, wobei 0,5 b < a < b gilt und b diejenige Dicke einer Schicht des gleichen Materials ist, bei welcher die Transmission von Weißlicht 0,1 % bis 0,2 % beträgt. Durch die teilweise Absorption des sichtbaren Spektrums mittels Interferenzschichten lassen sich dekorative Effekte bei Flaschen und dergleichen erzielen. Blickt man etwa auf eine ursprünglich transparente Kunststoffflasche, die z. B. mit einer 25 nm dicken Aluminiumschicht überzogen ist, so entspricht die optische Wirkung einer 50 nm dicken Schicht auf einer ebenen Glasscheibe, weil die 25 nm dicke Schicht zweimal vorhanden ist, einmal auf der Vorderseite und einmal auf der Rückseite der Flasche.

Der mit der Erfindung erzielte Vorteil besteht insbesondere darin, dass durch teilweise Absorption des sichtbaren Spektrums durch Interferenzschichten dekorative Effekte erzeugt werden. Dabei wird eine gezielte Absorption oder Reflexion mindestens eines Frequenzbereichs des sichtbaren Lichts erreicht. Die Tatsache, dass die Schichten relativ dünn sind, hat keinen negativen Einfluss auf die Sperrwirkung dieser Schichten, denn die Sperrung von Metallschichten gegen Gasdiffusion hängt nicht linear mit ihrer Dicke zusammen. Dünnere Schichten können sogar eine größere Sperrwirkung haben als dickere Schichten. Dies ist möglicherweise dadurch bedingt, dass die im Flaschenmaterial vorhandenen Mikroporen, durch die der Gastransport erfolgt, durch die dünne Barriereschicht verstopft werden. Mit zunehmender Schichtdicke der Barriere treten dagegen vor allem auf flexiblem Material wie PET Risse in der Barriereschicht auf, sodass das Gas entlang dieser Risse entweichen kann.

Ein Ausführungsbeispiel ist in der Zeichnung dargestellt und wird im Folgenden näher beschrieben. Es zeigen:
Fig. 1 eine Kunststoffflasche für Wasser oder Limonade;
Fig. 2 eine Anlage für die Beschichtung einer Kunststoffflasche mit einem Metall;
Fig. 3 eine Anlage für die Beschichtung einer Kunststoffflasche mit einem Metall, einem Metalloxid, Metallnitrid oder Metalloxinitrid und/oder einem zweiten Metall;
Fig. 4 den Reflexionsgrad eines Zweischichtsystems in Abhängigkeit von verschiedenen Lichtwellenlängen;
Fig. 5 den Reflexionsgrad eines ersten Dreischichtsystems in Abhängigkeit von verschiedenen Lichtwellenlängen;
Fig. 6 den Reflexionsgrad eines zweiten Dreischichtsystems in Abhängigkeit von verschiedenen Lichtwellenlängen;
Fig. 7 den Reflexionsgrad eines dritten Dreischichtsystems in Abhängigkeit von verschiedenen Lichtwellenlängen.

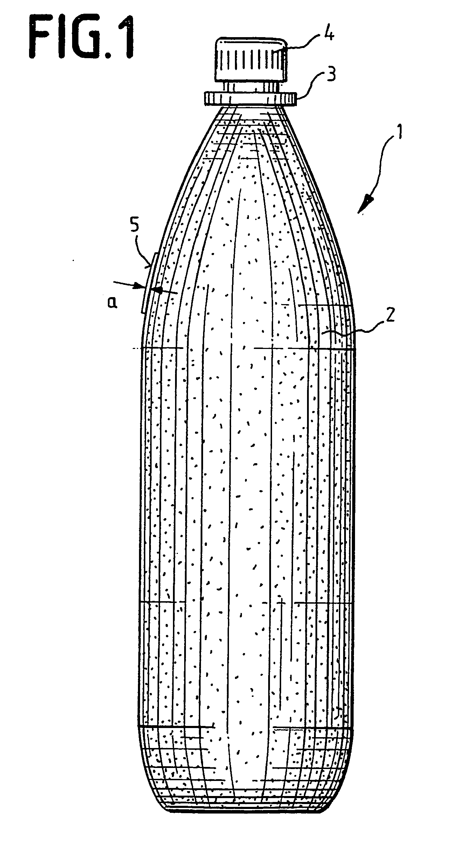

In der Fig. 1 ist eine Kunststoffflasche 1 dargestellt, die aus einem Aufnahmebehälter 2 für ein Getränk, einem Kragen 3 und einem Verschluss 4 besteht. Der Aufnahmekörper 2 und der Kragen 3 bestehen beispielsweise aus PET und sind klarsichtig. Um diese klarsichtige Kunststoffflasche 1 mit einem Farbeffekt zu versehen, wird über den ganzen Aufnahmebehälter 2 oder über Teile dieses Aufnahmebehälters 2 eine Metallschicht 5 aufgebracht, die in Fig. 1 lediglich angedeutet ist. Diese Metallschicht hat eine Dicke a, die zwischen 0,5 b und b liegt, wobei b die Dicke der Metallschicht ist, bei der sie eine mit Weißlicht gemessene Transmission von ca. 0,1 % bis 0,2 % aufweist.

Die nachfolgende Tabelle zeigt, bei welchen Schichtdickenbereichen a auf eine Kunststoffflasche aufgetragener Metallschichten eine genügend hohe Reflexion bei nicht störend auffallender Transmission aufweisen.

| **Metall** | **Schichtdickenbereich [nm]** | **Farbe** |
|---|---|---|
| Titan (Ti) | 30 - 40 | Silbrig |
| Chrom (Cr) | 40 - 60 | Silberhell |
| Zinn (Sn) | 40 - 60 | Silberweiß |
| Kupfer (Cu) | 30 - 50 | Rotbraun |
| Gold (Au) | 50 - 70 | Goldfarben |
| Edelstahl | 40 - 60 | Silberweiß |
| CuAl (10) | 60 - 80 | Gold-, messingfarben |
| Neodym (Nd) | ? | Silbrig bis schwach gelblich |
| Wolfram (W) | 30 - 50 | Weißglänzend |
| Molybdän (Mo) | 20 - 40 | Zinnweiß |
| Niob (Nb) | 20 - 40 | Hellgrau (aufpoliert weiß glänzend) |
| Palladium (Pd) | 30 - 50 | Silberhell |
| Aluminium (A1) | 20 - 40 | Silberweiß |
| Tantal (Ta) | 40 - 60 | Platingrau |
| Rhodium (Rh) | 30 - 50 | Silberweiß |
| Platin (Pt) | 40 - 60 | Grau bis silber |

Wird das zinnweiße Molybdän an der Luft erhitzt, bildet sich eine blaue festhaftende und schützende Oxidschicht. Tantal überzieht sich an der Luft mit einer schützenden Oxidschicht. Dasselbe gilt für Aluminium.

Die Farben der in der Tabelle genannten Metalle sind meist grau bis silberweiß, also "metallisch". Werden sie auf Kunststoffflaschen aufgetragen, beispielsweise mit Hilfe eines Sputterprozesses, erscheinen die Flaschen mehr oder weniger spiegelnd.

Gemäß der Erfindung kann die Schicht eine Dicke a haben, die im Bereich der in der obigen Tabelle angegebenen Schichtdickenbereiche liegt, weil sich bei einem räumlichen Hohlkörper die optischen Schichtdicken aus der Sicht des Betrachters addieren.

Blickt man auf die Flasche 1, die beispielsweise rundum mit einer 25 nm dicken Aluminiumschicht 5 überzogen ist, so entspricht die optische Wirkung einer 50 nm dicken Schicht auf einer ebenen Glasscheibe, weil die 25 nm dicke Schicht zweimal vorhanden ist, einmal auf der Vorderseite der Flasche und einmal auf deren Rückseite. Das Licht, das auf der Vorderseite durch die Aluminiumschicht tritt, wird auf der Rückseite noch einmal reflektiert. Dies gilt jedoch nur in solchen Fällen, in denen sich eine klare Flüssigkeit in der Flasche 1 befindet, also etwa Wasser.

Das Licht, das von der Außenseite auf die Metallschicht der Kunststoffflasche trifft, wird schon bei der halben Schichtdicke b großenteils reflektiert und nur ein kleiner Teil der Intensität gelangt in das Innere der Flasche. Dieses Licht trifft dann auf der gegenüberliegenden Seite erneut auf eine Metallschicht, wobei auch wieder ein Großteil des Lichts zurück in die Flasche reflektiert wird. Der Anteil der Intensität, der jetzt noch durch die - zweite - Metallschicht nach außen dringt, ist so gering, dass dieser transmittierte Teil gegenüber dem an der Außenseite reflektierten Licht nicht bemerkt wird, und die Flasche erscheint nur als reflektierend, obwohl die Einzelschicht von der Stärke a als teilweise transparent erscheinen würde, z. B. wenn die Flasche von innen beleuchtet würde.

Transmission (Tr), Reflexion (R) und Absorption (A) addieren sich bekanntlich zu 100 %: Tr + R + A = 100 %. Bei einer klaren Flasche mit klarem Getränk und der dünnen Metallschicht kann die Absorption vernachlässigt werden, es ist ca. A = 0. Realistische Werte für eine 25 nm dicke Aluminiumschicht sind ca. 92 % Reflexion und ca. 8 % Transmission an der ersten Metallschicht, d. h. von dem auf die Flasche einfallenden Licht gelangen nur 8 % in das Innere. Von diesen 8 % der ursprünglichen Intensität werden erneut 92 % reflektiert, und nur weitere 8 % davon treten durch die rückwärtige Schicht nach außen. D. h. durch die erste und zweite Schicht hindurch kommen nur noch 0,4 % der ursprünglichen Intensität auf der Rückseite an. Betrachtet man eine Flasche von der Vorderseite, werden diese 0,4 % Transmission durch beide Schichten neben den 92 % Reflexion an der Vorderseite nicht bemerkt, da der Kontrast sehr stark ist.

Mit einer dickeren Metallschicht würde man also weder eine bessere Gasbarriere erhalten noch eine Metalloberfläche, die subjektiv als noch besser reflektierend wirken würde. Messbar wäre die höhere Reflexion der dickeren Metallschicht allerdings. Es zeigt sich somit, dass sich durch die dünnere Beschichtung eine genügend gute Barriere gegen Gasdiffusion und eine metallisch wirkende Flaschenoberfläche erzeugen lässt. Man spart gleichzeitig Material, Prozesszeit und Kosten.

Enthält die Flasche 1 ein dunkles Getränk oder einen Saft, so wird der durch die erste Schicht hindurch gelassene etwa 8%ige Anteil der einfallenden Lichtintensität in der Flüssigkeit durch Absorption zusätzlich abgeschwächt, sodass an der zweiten Schicht der Flaschenrückseite eine noch schwächere Intensität ankommt, die durch die Transmission durch die zweite Schicht weiter abgeschwächt wird. Die ca. 92%ige Reflexion an der rückseitigen Metallschicht wird dadurch jedoch nicht beeinflusst, sodass die Aluminiumschicht trotz der dünnen Schichtstärke für den Betrachter metallisch reflektiert und nicht dunkel erscheint.

Metallschichten mit den in der Tabelle angegebenen Schichtdicken a zeigen einen Kontrast zwischen dem an der Vorderseite reflektierten Licht und dem von hinten durch beide Schichten hindurch tretenden Lichtanteil, der mehr als ausreichend hoch ist. Die Verwendung von Metallschichten einer solch geringen Dicke ist für die Beschichtung von großen Mengen von Flaschen von Bedeutung. Es kann damit ein hoher Beschichtungs-Durchsatz erreicht werden, was für die erfindungsgemäße Schichtabscheidung mittels der Sputtertechnik von hoher Bedeutung ist. Die durch Sputtern aufgebrachten Schichten zeigen bekanntermaßen eine bessere Haftung zum Substrat als aufgedampfte Schichten. Andererseits ist auch bekannt, dass Sputtern unter sehr viel kleineren Depositionsraten erfolgt als beim Aufdampfen, sodass es nicht naheliegend ist, für einen hohen Durchsatz von mindestens 20.000 Flaschen pro Stunde die Sputtertechnik anzuwenden.

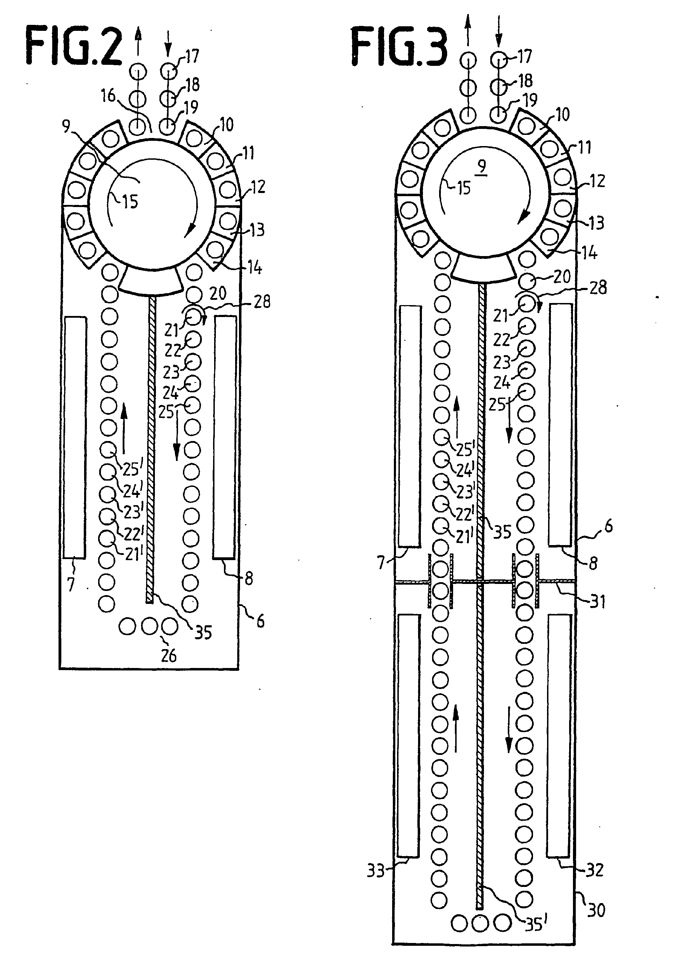

Die Fig. 2 zeigt schematisch eine Anlage zum Beschichten von Kunststoffflaschen mit Metall. Eine Vakuum-Beschichtungskammer 6 enthält hierbei auf zwei Seiten jeweils wenigstens eine Magnetronkathode 7, 8. Statt einer Kathode können auf jeder Seite auch mehrere Kathoden hintereinander angeordnet sein. Zwischen den Kathoden 7, 8 kann auch noch eine Trennwand 35 vorgesehen sein. Am Eingang zur Vakuum-Beschichtungskammer 6 befindet sich eine Schleusenkammer 9, die auf einem Kreisring mehrere Aufnahmekammern 10 bis 14 aufweist. Diese Schleusenkammer 9 dreht sich im Uhrzeigersinn, was durch den Pfeil 15 angedeutet ist. Am Eingang 16 der Schleusenkammer 9 herrscht Atmosphärendruck. Es werden dort nicht beschichtete Kunststoffflaschen 17, 18, 19 auf eine nicht dargestellte lineare Fördereinrichtung gestellt, die dann in eine kreisringförmige Fördereinrichtung übergeht. Hierdurch werden die Flaschen, die sich auf der Fördereinrichtung befinden, von der Atmospähre in das Hochvakuum der Beschichtungskammer 6 gebracht. Dort gelangen die Flaschen, von denen einige mit Bezugszahlen 21 bis 25 versehen sind, unter Drehung um ihre Längsachse, was durch den Pfeil 28 angedeutet ist, wieder auf eine nicht dargestellte lineare Fördereinrichtung, mit deren Hilfe sie an der Magnetronkathode 8 bzw. an einer Reihe von Magnetronkathoden vorbeigeführt werden. Von den Metall-Targets dieser Magnetronkathoden werden Metallpartikel abgesputtert, die dann auf die Außenflächen der Kunststoffflaschen gelangen. Die Flaschen in der Vakuum-Beschichtungskammer 6 drehen sich alle ständig um die eigene Längsachse, und zwar mindestens so schnell, dass eine 360°-Drehung erreicht wird, bevor die Flasche eine Magnetronkathode passiert hat. Eine gleichmäßigere Verteilung der Beschichtung erhält man, wenn die Rotation der Flasche ein Mehrfaches annimmt. Am Ende 26 der rechtsseitigen Beschichtungsstrecke machen die sich drehenden Flaschen eine Kehrtwendung von 180 Grad und werden nun von der zweiten Magnetronkathode 7 aus mit Metallpartikeln beschichtet.

Mit der Anlage gemäß Fig. 2 können die Kunststoffflaschen metallisiert werden. Die Metallisierung bewirkt dabei eine gute Sperrwirkung gegen flüchtige Substanzen in einem Getränk und gleichzeitig gibt sie der Flasche ein edles Aussehen.

Ein wirklich farbiges Aussehen wird dabei jedoch noch nicht erreicht.

Ein Farbeffekt kann indessen durch das Aufbringen wenigstens einer weiteren Schicht erreicht werden, beispielsweise einer durchsichtigen Oxid- oder Nitridschicht. Aluminium, Chrom und außerdem Silizium als Nichtmetall bilden transparente Nitridschichten. Die Nitride der Übergangsmetalle wie Ti, Zr, Nb und Ta zeigen metallische Eigenschaften wie z. B. elektrische Leitfähigkeit und Absorption. Dickere Schichten aus TiN sind goldfarben, die aus ZrN sind messingfarben. Die Oxid- oder Nitridschichten müssen nur transparent sein, wenn sie in Schichtsystemen vorkommen, die aus wenigstens einer Metallschicht und einer dielektrischen bzw. keramischen Schicht bestehen. Eine Beschichtung aus z. B. Titannitrid ist goldfarben und kann als Einzelschicht wie Gold oder Kupfer oder Kupfer-Aluminium eine dekorative Schicht mit Barrierewirkung bilden.

Ein Farbeffekt tritt dann auf, wenn auf eine erste Metallschicht eine durchsichtige Schicht aus Metalloxid, Metallnitrid oder Metalloxinitrid aufgebracht wird. Vorteilhaft sind hierbei auch Schichten, deren Sauerstoff- und/oder Stickstoffgehalt mit steigender Schichtdicke variiert, so genannte Gradientenschichten. Die Änderung der Zusammensetzung im Schichtaufbau erzeugt Defekte in der kristallinen Struktur, so genannte Versetzungen. Durch diese Versetzungen werden eventuell in der Schicht vorhandene Mikroporen geschlossen, was die Barrierewirkung einer solchen Schicht erhöht. Da auch der Brechungsindex mit der Schichtzusammensetzung variiert, muss die Schichtdicke angepasst werden, wenn man dieselbe Farbe erreichen will, die man mit einer Schicht mit konstanter Zusammensetzung erhalten hätte.

Die nachfolgende Tabelle zeigt einige Beispiele von Mehrfach-Beschichtungen, wobei Aluminium als Reflexionsschicht dient. Die Stärke der Aluminiumschicht spielt hierbei keine Rolle, sodass die Schichtdicke nicht angegeben ist. Bei flächiger Beschichtung ergibt sich bei einer Schichtdicke von etwa 30 bis 40 nm eine genügend hohe Reflexion, während die Transmission etwa zwischen 5 % und 1 % liegt. Eine Verstärkung der Aluminium-Schichtdicke ist zwar möglich, bringt aber keine Verbesserung des Reflexionsgrads. Es zeigt sich, dass sich mit einer Einzelschicht auf Aluminium ein schwächer ausgeprägter Farbeffekt erzielen lässt als mit einem Dreischichtsystem, das den Fabry-Perot-Effekt ausnutzt, durch den viele Strahlen zur Interferenz gebracht werden. Mit x und y sind die Farbkoordinaten im CIE-System angegeben. PET ist das Grundsubstrat, auf dem die Schichten aufgebracht werden.

| **Schicht** | **PET** | **PET** | **PET** | **PET** |
|---|---|---|---|---|
| 1 | A1 | A1 | A1 | A1 |
| 2 | 50 nm TiO₂ | 70 nm TiO₂ | 50 nm TiO₂ | 130 nm SiO₂ |
| 3 | | 8 nm A1 | 8 nm A1 | 5 nmA1 |
| Farbkoordination | | | | |
| x | 0,28 | 0,27 | 0,39 | 0,24 |
| y | 0,3 | 0,17 | 0,44 | 0,14 |
| Farbe | blassbläulich | purpur | gelb | purpur |

In der Fig. 3 ist eine Anlage dargestellt, mit der Mehrfach-Beschichtungen vorgenommen werden können. Der obere Teil dieser Anlage entspricht weitgehend der Anlage gemäß Fig. 2, weshalb dort die gleichen Bezugszahlen verwendet sind. Der untere Teil der Anlage enthält eine weitere Beschichtungskammer 30, mit der eine zweite Schicht auf die erste Metallschicht aufgebracht werden kann. Mit 35 bzw. 35' sind Trennwände bezeichnet.

Zwischen der ersten Beschichtungskammer 6 und der zweiten Beschichtungskammer 30 befindet sich eine Gastrennwand 31, weil zur Erzeugung von Oxiden und anderen Verbindungen im zweiten Beschichtungsraum 30 reaktiv gesputtert wird, d. h. außer dem Edelgas, z. B. Argon, das zum Sputtern erforderlich ist, wird noch ein Reaktivgas in den Beschichtungsraum 30 eingeführt. Die Gase der Beschichtungskammern 6, 30 dürfen deshalb nicht miteinander vermischt werden. Nach der Beschichtung mit einem Metall, z. B. Aluminium, mittels der Magnetronkathode 8, gelangen die Flaschen in die Beschichtungskammer 30 und werden dort z. B. mit reaktiv gewonnenem TiO₂ beschichtet, wobei Ti von einer Magnetronkathode 32 abgesputtert wird.

Die eingeschleusten Flaschen erhalten also zunächst eine einzige Metallschicht, gelangen durch die Gastrennvorrichtung 31 in die zweite Beschichtungskammer, in der unter Reaktivgasatmosphäre gesputtert wird, und erhalten hier ihre transparente Oxid- oder Nitridschicht. Da die Beschichtungsrate bei reaktiven Sputterprozessen niedriger ist als bei metallischem Sputtern, ist es vorteilhaft, die Magnetronkathode so anzuordnen, wie in Fig. 3 dargestellt, weil hierdurch der langsamere Prozess mit zwei identischen Beschichtungsstationen erfolgt. Es könnte auch eine Kathode mit doppelter Länge vorgesehen werden, was aber die bereits beschriebenen Nachteile zur Folge hätte. Nach weiterem Durchqueren der Gastrennvorrichtung 31 werden die Flaschen nun an der vierten Kathode mit der zweiten Metallschicht versehen.

Zwischen den beiden gegenüberliegenden Kathoden in einem Anlagensegment können durchaus die Trennwände 35, 35' vorgesehen werden, wenn die erste und die zweite Metallschicht nicht aus demselben Material bestehen sollen. Sind beide Metallschichten aus demselben Metall vorgesehen, kann man die Ausnutzung des von einem Target abgesputterten Materials noch dadurch erhöhen, dass das Metall, das zwischen zwei Flaschen hindurch fliegt, die Flaschen auf der gegenüber liegenden Seite mit beschichtet. Dadurch erhöht sich auch die Beschichtungsrate der metallischen Beschichtung, und die Anlagenverschmutzung durch Beschichten von Kammerwänden wird reduziert.

Die auf diese Weise mit einer Al- und TiO₂-Schicht versehenen Flaschen können nun mittels der Magnetronkathode 7 mit einer weiteren Aluminiumschicht oder mit einer anderen Metallschicht versehen werden. Dieser Vorteil der Anordnung der Magnetronkathoden 7, 8, 32 und 33 lässt sich aber nur dann ausnutzen, wenn sich die Flaschen 1 auf allen Positionen zusätzlich zu der linearen Bewegung der Fördereinrichtung um ihre eigene Längsachse drehen.

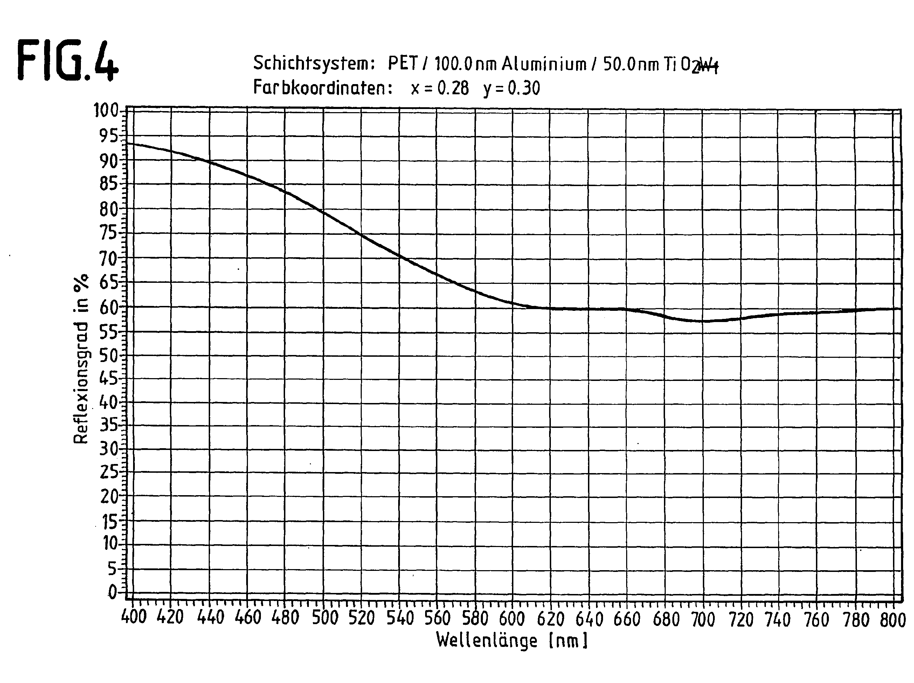

In der Fig. 4 ist der Reflexionsgrad eines Zweischichtsystems über der Lichtwellenlänge dargestellt. Dieses Zweischichtsystem besteht aus einer Aluminiumschicht von 100 nm Stärke und einer 50 nm starken TiO₂-Schicht, wobei aber die Stärke der Aluminiumschicht nicht ausschlaggebend ist, da diese nur als Reflexionsschicht dient. Die Farbkoordinaten dieser Reflexionskurve sind x = 0,28 und y = 0,3, d. h. die Beschichtung erscheint blassblau, weil im blauen Bereich stärker als im roten Bereich reflektiert wird. Mit einer 30 bis 40 nm dicken Aluminiumschicht erhält man eine sehr ähnliche Farbwirkung bei etwas reduzierten Reflexionswerten, die aber dem Betrachter kaum auffallen.

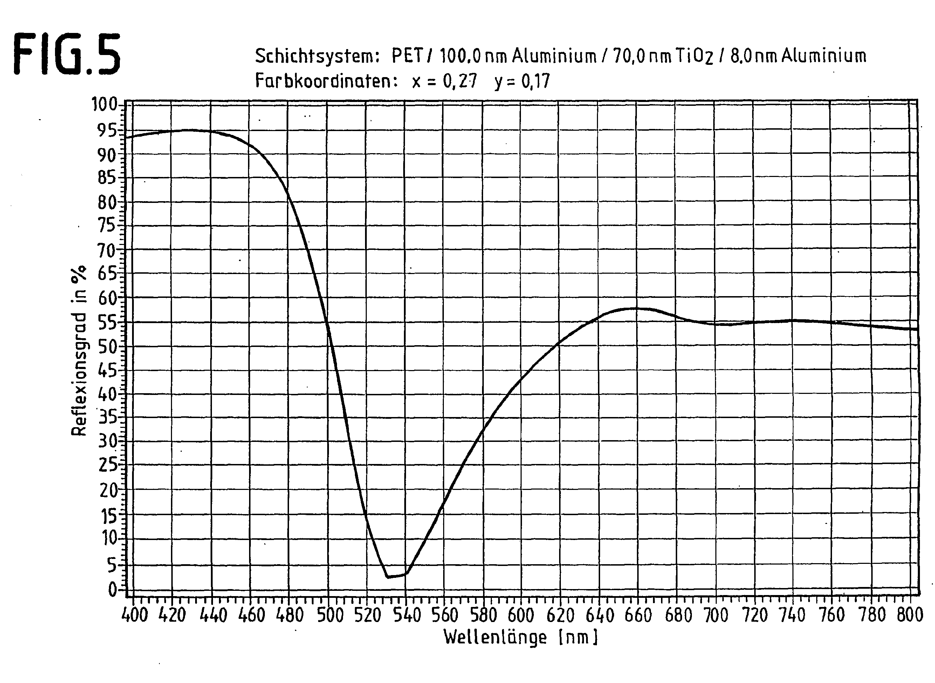

Die Fig. 5 zeigt ein Dreischichtsystem, das aus Aluminium von der Stärke b, 70 nm TiO₂ und 8 nm Aluminium besteht. Man erkennt hierbei, dass der Reflexionsgrad im grün-gelben Bereich stark zurückgeht, während er im blauen Bereich sehr hoch und im roten Bereich mittel ist. Die sich hieraus ergebende Farbe ist purpur, deren Farbkoordinaten x = 0,27 und y = 0,17 sind.

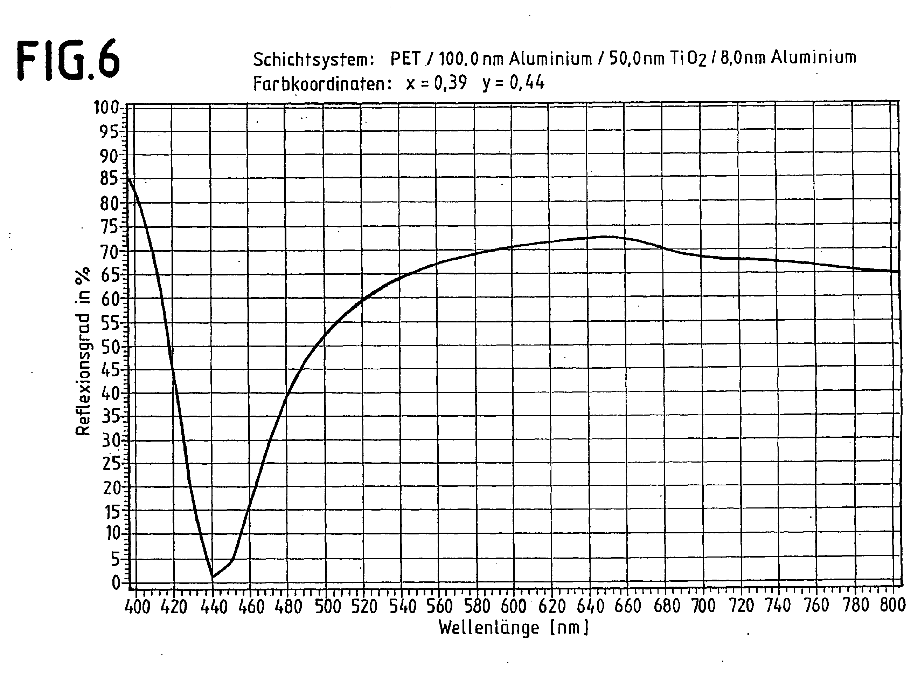

In der Fig. 6 ist ein weiteres Dreischichtsystem gezeigt, das aus Aluminium, 50 nm TiO₂ und 8 nm Aluminium besteht. Der Reflexionsgrad wird hierdurch im blauen Bereich sehr klein und im gelben und roten Bereich relativ groß. Die sich ergebende Farbe hat die Koordinaten x = 0,39 und y = 0,44, d. h. sie ist gelb.

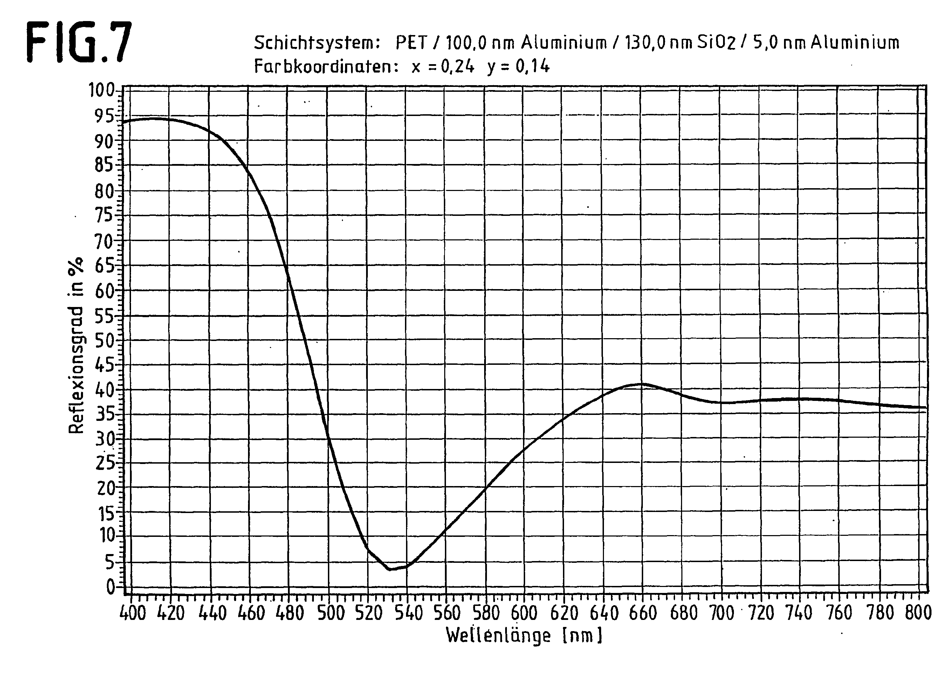

Fig. 7 zeigt den Reflexionsgrad eines weiteren Dreischichtsystems, das aus Aluminium, 130 nm Si O₂ und 5 nm Aluminium besteht. Im Bereich von 530 nm ist der Reflexionsgrad sehr klein, während er im Bereich von 400 bis 440 nm sehr groß und im Bereich von 640 bis 800 nm mittel ist. Die Farbkoordinaten liegen bei x = 0,24 und y = 0,14, was der Farbe purpur entspricht. Dieses Schichtsystem stellt eine Alternative zu der in Fig. 5 gezeigten Lösung dar, d. h. es lassen sich mit anderen Materialien und den entsprechenden Schichtdicken sehr ähnliche Farbwirkungen erzielen.

## Patentansprüche

1. Räumlicher Hohlkörper aus transparentem Kunststoff, mit einer Beschichtung, die eine Sperrung gegenüber Gasen und/oder Dämpfen besitzt und die wenigstens eine Schicht eines Materials enthält, bei dem die Absorption von Licht im sichtbaren Bereich vernachlässigbar ist, und wobei für die Dicke a dieser Schicht 0,5 b < a < b gilt, wobei b diejenige Dicke einer Schicht des gleichen Materials ist, bei welcher die Transmission von Weißlicht 0,1 % bis 0,2 % beträgt.

2. Räumlicher Hohlkörper nach Anspruch 1, **dadurch gekennzeichnet, dass** die wenigstens eine Schicht aus Metall besteht.

3. Räumlicher Hohlkörper nach Anspruch 1, **dadurch gekennzeichnet, dass** die wenigstens eine Schicht aus einem Nitrid der Übergangsmetalle wie Ti, Zr, Nb und Ta besteht.

4. Räumlicher Hohlkörper nach Anspruch 2, **dadurch gekennzeichnet, dass** das Metall zur Gruppe Molybdän, Niob, Palladium, Aluminium, Tantal, Rhodium, Platin, Titan, Chrom, Zinn, Kupfer, Gold, Neodym, Wolfram, Zirkonium gehört.

5. Räumlicher Hohlkörper nach Anspruch 2, **dadurch gekennzeichnet, dass** auf der Metallschicht eine durchsichtige Oxidschicht aufgebracht ist.

6. Räumlicher Hohlkörper nach Anspruch 2, **dadurch gekennzeichnet, dass** auf der Metallschicht eine durchsichtige Nitridschicht aufgebracht ist.

7. Räumlicher Hohlkörper nach Anspruch 2, **dadurch gekennzeichnet, dass** die Beschichtung aus Molybdän, Aluminium oder Niob eine Stärke von 20 nm bis 40 nm hat.

8. Räumlicher Hohlkörper nach Anspruch 2, **dadurch gekennzeichnet, dass** die Beschichtung aus Tantal, Chrom, Zinn oder Platin eine Stärke von 40 nm bis 60 nm hat.

9. Räumlicher Hohlkörper nach Anspruch 2, **dadurch gekennzeichnet, dass** die Beschichtung aus Palladium, Kupfer, Wolfram oder Rhodium eine Stärke von 30 nm bis 50 nm hat.

10. Räumlicher Hohlkörper nach Anspruch 2, **dadurch gekennzeichnet, dass** die Beschichtung aus Titan eine Stärke von 30 nm bis 40 nm hat.

11. Räumlicher Hohlkörper nach Anspruch 2, **dadurch gekennzeichnet, dass** die Beschichtung aus Gold eine Stärke von 50 bis 70 nm hat.

12. Räumlicher Hohlkörper nach Anspruch 2, **dadurch gekennzeichnet, dass** das Metall eine Metalllegierung ist.

13. Räumlicher Hohlkörper nach Anspruch 12, **dadurch gekennzeichnet, dass** die Metalllegierung aus Kupfer und Aluminium besteht und eine Stärke von 60 nm bis 80 nm hat.

14. Räumlicher Hohlkörper nach Anspruch 12, **dadurch gekennzeichnet, dass** die Metalllegierung aus Edelstahl besteht und eine Stärke von 40 nm bis 60 nm hat.

15. Räumlicher Hohlkörper nach Anspruch 5, **dadurch gekennzeichnet, dass** die Oxidschicht aus SiO₂ besteht.

16. Räumlicher Hohlkörper nach Anspruch 2, **dadurch gekennzeichnet, dass** die Metallschicht aus Aluminium besteht, auf der sich eine TiO₂-Schicht befindet.

17. Räumlicher Hohlkörper nach Anspruch 16, **dadurch gekennzeichnet, dass** sich auf der TiO₂-Schicht eine weitere Aluminium-Schicht befindet.

18. Räumlicher Hohlkörper nach Anspruch 2, **dadurch gekennzeichnet, dass** die Metallschicht aus Aluminium besteht, auf der sich eine SiO₂-Schicht befindet.

19. Räumlicher Hohlkörper nach Anspruch 18, **dadurch gekennzeichnet, dass** sich auf der SiO₂-Schicht eine weitere Aluminium-Schicht befindet.

20. Räumlicher Hohlkörper nach Anspruch 16, **dadurch gekennzeichnet, dass** die TiO₂-Schicht eine Stärke von 50 nm besitzt.

21. Räumlicher Hohlkörper nach Anspruch 17, **dadurch gekennzeichnet, dass** die TiO₂-Schicht eine Stärke von 70 nm hat und sich auf dieser TiO₂-Schicht eine Aluminium-Schicht von 8 nm Stärke befindet.

22. Räumlicher Hohlkörper nach Anspruch 20, **dadurch gekennzeichnet, dass** sich auf der TiO₂-Schicht eine Aluminium-Schicht von 8 nm Stärke befindet.

23. Räumlicher Hohlkörper nach Anspruch 19, **dadurch gekennzeichnet, dass** sich auf der SiO₂-Schicht eine Aluminium-Schicht von 5 nm Stärke befindet.

24. Räumlicher Hohlkörper nach Anspruch 1, **dadurch gekennzeichnet, dass** die wenigstens eine Schicht aus einem Oxinitrid besteht.

## Claims

1. Three-dimensional hollow body comprised of transparent synthetic material, with a coating having a barrier effect against gases and/or vapors and containing at least one layer of a material, in which the absorption of light in the visible range is negligible, and wherein to the thickness a of the layer 0.5 **b** < **a** < **b** applies, wherein b is the thickness of a layer of the same material at which the transmission of white light is 0.1% to 0.2%.

2. Three-dimensional hollow body as claimed in claim 1, **characterized in that** the at least one layer is comprised of metal.

3. Three-dimensional hollow body as claimed in claim 1, **characterized in that** the at least one layer is comprised of a nitride of the transition metals such as Ti, Zr, Nb and Ta.

4. Three-dimensional hollow body as claimed in claim 2, **characterized in that** the metal belongs to the group molybdenum, niobium, palladium, aluminum, tantalum, rhodium, platinum, titanium, chromium, tin, copper, gold, neodymium, tungsten, zirconium.

5. Three-dimensional hollow body as claimed in claim 2, **characterized in that** onto the metal layer a transparent oxide layer is applied.

6. Three-dimensional hollow body as claimed in claim 2, **characterized in that** onto the metal layer a transparent nitride layer is applied.

7. Three-dimensional hollow body as claimed in claim 2, **characterized in that** the coating of molybdenum, aluminum or niobium has a thickness of 20 nm to 40 nm.

8. Three-dimensional hollow body as claimed in claim 2, **characterized in that** the coating of tantalum, chromium, tin or platinum has a thickness of 40 nm to 60 nm.

9. Three-dimensional hollow body as claimed in claim 2, **characterized in that** the coating of palladium, copper, tungsten or rhodium has a thickness of 30 nm to 50 nm.

10. Three-dimensional hollow body as claimed in claim 2, **characterized in that** the coating of titanium has a thickness of 30 nm to 40 nm.

11. Three-dimensional hollow body as claimed in claim 2, **characterized in that** the coating of gold has a thickness of 50 to 70 nm.

12. Three-dimensional hollow body as claimed in claim 2, **characterized in that** the metal is a metal alloy.

13. Three-dimensional hollow body as claimed in claim 12, **characterized in that** the metal alloy is comprised of copper and aluminum and has a thickness of 60 nm to 80 nm.

14. Three-dimensional hollow body as claimed in claim 12, **characterized in that** the metal alloy is comprised of special steel and has a thickness of 40 nm to 60 nm.

15. Three-dimensional hollow body as claimed in claim 5, **characterized in that** the oxide layer is comprised of SiO₂.

16. Three-dimensional hollow body as claimed in claim 2, **characterized in that** the metal layer is comprised of aluminum on which is disposed a TiO₂ layer.

17. Three-dimensional hollow body as claimed in claim 16, **characterized in that** on the TiO₂ layer is disposed a further aluminum layer.

18. Coating as claimed in claim 2, **characterized in that** the metal layer is comprised of aluminum on which is disposed an SiO₂ layer.

19. Three-dimensional hollow body as claimed in claim 18, **characterized in that** on the SiO₂ layer is disposed a further aluminum layer.

20. Three-dimensional hollow body as claimed in claim 16, **characterized in that** the TiO₂ layer has a thickness of 50 nm.

21. Three-dimensional hollow body as claimed in claim 17, **characterized in that** the TiO₂ layer has a thickness of 70 nm and that on this TiO₂ layer an aluminum layer of a thickness of 8 nm is disposed.

22. Three-dimensional hollow body as claimed in claim 20, **characterized in that** on the TiO₂ layer is disposed an aluminum layer having a thickness of 8 nm.

23. Three-dimensional hollow body as claimed in claim 19, **characterized in that** on the SiO₂ layer is disposed an aluminum layer having a thickness of 5 nm.

24. Three-dimensional hollow body as claimed in claim 1, **characterized in that** the at least one layer is comprised of an oxinitride.

## Revendications

1. Corps creux tridimensionnel en plastique transparent avec un revêtement qui possède un blocage contre les gaz et/ou les vapeurs et qui contient au moins une couche d'un matériau pour lequel l'absorption de lumière dans une zone visible est négligeable et pour lequel pour l'épaisseur *a* de cette couche on a 0,5 b < *a* < *b*, pour lequel b est l'épaisseur d'une couche du même matériau pour lequel la transmission de lumière blanche est de 0,1 % à 0,2 %.

2. Corps creux tridimensionnel selon la revendication 1 **caractérisé en ce qu'**au moins une couche est composée de métal.

3. Corps creux tridimensionnel selon la revendication 1 **caractérisé en ce qu'**au moins une couche est composée d'un nitrure des métaux de transition comme le Ti, le Zr, le Nb et le Ta.

4. Corps creux tridimensionnel selon la revendication 2 **caractérisé en ce que** le métal appartient au groupe molybdène, niobium, palladium, aluminium, tantale, rhodium, platine, titane, chrome, étain, cuivre, or, néodyme, tungstène, zirconium.

5. Corps creux tridimensionnel selon la revendication 2 **caractérisé en ce qu'**une couche d'oxyde transparente soit appliquée à la couche de métal.

6. Corps creux tridimensionnel selon la revendication 2 **caractérisé en ce qu'**une couche de nitrure transparente soit appliquée à la couche de métal.

7. Corps creux tridimensionnel selon la revendication 2 **caractérisé en ce que** le revêtement est en molybdène, aluminium ou nobium d'une épaisseur de 20 nm à 40 nm.

8. Corps creux tridimensionnel selon la revendication 2 **caractérisé en ce que** le revêtement en tantale, chrome, étain ou platine est d'une épaisseur de 40 nm à 60 nm.

9. Corps creux tridimensionnel selon la revendication 2 **caractérisé en ce que** le revêtement en palladium, cuivre, tungstène ou rhodium, est d'une épaisseur de 30 nm à 50 nm.

10. Corps creux tridimensionnel selon la revendication 2 **caractérisé en ce que** le revêtement en titane est d'une épaisseur de 30 nm à 40 nm.

11. Corps creux tridimensionnel selon la revendication 2 **caractérisé en ce que** le revêtement en or est d'une épaisseur de 50 nm à 70 nm.

12. Corps creux tridimensionnel selon la revendication 2 **caractérisé en ce que** le métal est un alliage de métaux.

13. Corps creux tridimensionnel selon la revendication 12 **caractérisé en ce que** l'alliage de métaux est composé de cuivre et d'aluminium et est d'une épaisseur de 60 nm à 80 nm.

14. Corps creux tridimensionnel selon la revendication 12 **caractérisé en ce que** l'alliage de métaux est composé d'acier spécial et est d'une épaisseur de 40 nm à 60 nm.

15. Corps creux tridimensionnel selon la revendication 5 **caractérisé en ce que** la couche d'oxyde est composée de SiO₂.

16. Corps creux tridimensionnel selon la revendication 2 **caractérisé en ce que** la couche métallique est composée d'aluminium sur laquelle se trouve une couche de TiO₂.

17. Corps creux tridimensionnel selon la revendication 16 **caractérisé en ce que** sur la couche de TiO₂ se trouve une autre couche d'aluminium.

18. Corps creux tridimensionnel selon la revendication 2 **caractérisé en ce que** la couche métallique est composée d'aluminium sur laquelle se trouve une couche de SiO₂

19. Corps creux tridimensionnel selon la revendication 18 **caractérisé en ce que** sur la couche de SiO₂ se trouve une autre couche d'aluminium.

20. Corps creux tridimensionnel selon la revendication 16 **caractérisé en ce que** la couche de TiO₂ est d'une épaisseur de 50 nm.

21. Corps creux tridimensionnel selon la revendication 17 **caractérisé en ce que** la couche de TiO₂ est d'une épaisseur de 70 nm et que sur cette couche de TiO₂ se trouve une couche d'aluminium d'une épaisseur de 8 nm.

22. Corps creux tridimensionnel selon la revendication 20 **caractérisé en ce que** sur la couche de TiO₂ se trouve une couche d'aluminium de 8 nm d'épaisseur.

23. Corps creux tridimensionnel selon la revendication 19 **caractérisé en ce que** sur la couche de SiO₂ se trouve une couche d'aluminium de 5 nm d'épaisseur.

24. Corps creux tridimensionnel selon la revendication 1 **caractérisé en ce qu'**au moins une couche est composée d'un oxynitrure.
